# EUROPÄISCHE PATENTSCHRIFT

(11) **EP 1 524 215 B1**
(45) Veröffentlichungstag und Bekanntmachung des Hinweises auf die Patenterteilung: **02.08.2006**
(21) Anmeldenummer: 04019331.0
(22) Anmeldetag: 14.08.2004
(51) Int. Cl.: B65G 49/06

(54) **Vakuum-Behandlungsanlage für ebene rechteckige bzw. quadratische Substrate**
Vacuum processing chamber for planar rectangular in particular square substrate
Chambre sous vide de traitement pour substrat plan rectangulaire, en particulier carré

(30) Priorität: 17.10.2003 DE 10348281
(43) Veröffentlichungstag der Anmeldung: 20.04.2005
(73) Patentinhaber: Applied Films GmbH & Co. KG, 63755 Alzenau (DE)
(72) Erfinder: Lindenberg, Ralph, 63654 Büdingen (DE); Fuchs, Frank, 63826 Geiselbach-Ommersbach (DE); Schuessler, Uwe, 63743 Aschaffenburg (DE); Bangert, Stefan, 36396 Steinau (DE); Stolley, Tobias, 60598 Frankfurt/Main (DE)
(74) Vertreter: Zapfe, Hans

(56) Entgegenhaltungen:
- EP-A- 0 665 193
- BE-A- 648 039
- FR-A1- 2 307 770
- GB-A- 2 169 872
- US-A1- 2002 078 892
- PATENT ABSTRACTS OF JAPAN Bd. 2000, Nr. 26, 1. Juli 2002 (2002-07-01) -& JP 2001 253536 A (HIRATA CORP), 18. September 2001 (2001-09-18)

## Beschreibung

Die Erfindung betrifft eine Vakuum-Behandlungsanlage für ebene rechteckige bzw. quadratische Substrate in einer zumindest im wesentlichen senkrechten Stellung, enthaltend eine Vakuumkammer mit mindestens zwei auf den Umfang der Vakuumkammer verteilten kammerseitig offenen Behandlungskammern, eine Eintragsschleuse, eine Austragsschleuse und eine drehbare Anordnung von Substrathaltern innerhalb der Vakuumkammer mit einem Antriebsmechanismus für die sequentielle Rotation und den Vorschub und Rückzug der Substrathalter relativ zu den Behandlungskammern.

Kontinuierlich arbeitende Behandlungs- oder Beschichtungsanlagen, die unter Vakuum bis an die Leistungsgrenze der Vakuum-Pumpsätze betrieben werden und in denen unterschiedliche Behandlungen an sogenannten Substraten in einzelnen Behandlungsstationen durchgeführt werden, enthalten in der Regel folgende Baugruppen:
a) mindestens eine Vakuumkammer
b) mindestens ein Evakuierungs- bzw. Pumpensystem,
c) von der Vakuumkammer aus zugängliche Behandlungsstationen mit Behandlungsquellen,
d) ggf. innere Schleusenventile am Eingang der Behandlungsstationen,
e) Versorgungseinrichtungen für die Behandlungsquellen (Strom- und/oder Gasquellen),
f) mindestens ein Schleusensystem mit Schleusenventilen für das Ein- und Ausschleusen der Substrate in die und aus der Vakuumkammer,
g) Transportsysteme für den zwei- oder mehrdimensionalen Transport der Substrate,
h) Substrathalter oder -träger im Zusammenwirken mit den Transportsystemen und
i) ggf. vorgeschaltete Aggregate für die Bereitstellung und/oder den Abstransport der Substrate vor dem Schleusensystem der Anlage.

Soweit es sich um Anlagen mit rotatorischen und ggf. radialen Transportwegen und an mindestens eine, zumindest im wesentlichen rotationssymmetrische, Haupt-Vakuumkammer angeschlossenen Behandlungsstationen oder -kammern handelt, werden solche Anlagen auch als "Cluster-Anlagen" bezeichnet.

Bei den Behandlungsverfahren kommen die Vorwärmung (Ausgasen) und Abkühlung der Substrate, die Vakuum-Aufdampfung, die Katodenzerstäubung, die Plasmabehandlung (z.B. Glimmen zur Reinigung und Haftvermittlung), das PVD-Verfahren, das CVD-Verfahren und das PCVD-Verfahren zur Anwendung, für die zahlreiche Verfahrensparameter und Vorrichtungskomponenten bekannt sind. Hierbei steht "P" für "physical", "C" für "chemical, "V" für "vacuum" und "D" für "deposition". Einige dieser Verfahren, deren Bezeichnungen sich im internationalen Sprachgebrauch durchgesetzt haben, können reaktiv (unter Zufuhr von Reaktionsgasen oder Gasgemischen) oder nicht reaktiv (in Gegenwart von Inertgasen) durchgeführt werden. Hinzu kommen auch Ätzverfahren für die Oberflächenbehandlung einschließlich der Erzeugung bestimmter "Flächenmuster" und Kontaktlinien auf den Substraten. Sämtliche Verfahrensschritte und Vorrichtungskomponenten kommen auch - je nach den Anforderungen an die Endprodukte - für den Erfindungsgegenstand in Frage.

In der historischen Entwicklung wurden die kontinuierlichen "Cluster-Anlagen" zunächst für relative kleine Substrate wie Disketten, Chips, Datenspeicher und Wafer eingesetzt. Der Weiterentwicklung im Hinblick auf größere Substrate wie Fensterscheiben und Displays standen jedoch erheblich Probleme im Wege, wie z.B. die Abmessungen der Anlagen, der Platzbedarf für das Handling der Substrate und ggf. der Substrathalter, z.B. das Aufrichten von in horizontaler Lage zugeführten Substraten in eine im wesentlichen senkrechte Stellung, die Gefahr der elastischen Verformung, des Bruchs und/oder der mechanischen Beschädigung der Substrate und/oder deren Beschichtungen und die Verunreinigung, insbesondere durch die Ansammlung von Beschichtungen auf dauernd oder vorübergehend in den Anlagen befindlichen Komponenten und das Abplatzen dieser Verunreinigungen durch unterschiedliche Verfahrensparameter, insbesondere durch Temperaturänderungen oder mechanische Einwirkungen.

So wird z.B. gemäß der weiter unten noch abgehandelten EP 0 136 562 B1 jedes Substrat horizontal liegend einem Schleusensystem zugeführt, darin erst mittels einer Hubvorrichtung nach oben angehoben und dann durch eine Schwenkvorrichtung in eine senkrechte Stellung verschwenkt, in der es an einem Substrathalter befestigt wird. Beim Ausschleusen in einem zweiten Schleusensystem wird dann die Reihenfolge dieser Schritte umgekehrt. Dies würde bei großflächigen rechteckigen Substraten zu erheblichen Platzproblemen, großen Schleusen- und Kammervolumina sowie langen Evakuierungszeiten und/oder großen Saugleistungen der Vakuumpumpen führen.

Durch die EP 0 136 562 B1ist es bei einer kontinuierlichen Katodenzerstäubungsanlage für kleine kreisscheibenförmige Substrate wie Disketten, Halbleiter und Wafer bekannt, eine Vakuumkammer aus zwei topfförmigen Kammern zu bilden, nämlich aus einer 5-eckigen Außenkammer und einer dazu konzentrischen zylindrischen Innenkammer, die beide durch einen ringförmigen oberen Deckel fest und vakuumdicht miteinander verbunden sind. Die Böden haben einen geringen vertikalen Abstand voneinander. Die Außenkammer ist auf dem Umfang äquidistant mit einer Schleusenanlage und vier kammerförmigen Behandlungsstationen versehen. Solche Anlagen werden auch allgemein als "Cluster-Anlagen" bezeichnet.

Zwischen Außen- und Innenkammer ist drehbar ein weiterer polygonaler Topf angeordnet, an dessen Zarge fünf Substrathalter mittels Blattfedern angeordnet sind, die in Betriebsstellung die Schleusenanlage sowie die Bearbeitungskammern mittels Dichtungen und einer Ventilfunktion verschließen. Auch der Substrathalter-Topf hat einen Boden, der zwischen den Böden von Außen- und Innenkammer angeordnet ist. Die Radialbewegungen der Substrathalter, die ständig in der Vakuumkammer verbleiben, werden synchron durch einen zentralen Kegel und fünf Schubstangen erzeugt, die in der Zarge der Innenkammer und durch deren Wand in etwa halber Höhe hindurch geführt sind und sich infolgedessen nicht mitdrehen können. Stationär ist auch der Antrieb mit seinem Kegel.

Der Substrathalter-Topf wird schrittweise durch einen weiteren Antrieb gedreht. Um den Substrathalter-Topf innerhalb der Vakuumkammer von Station zu Station drehen zu können, müssen die besagten Schubstangen aus der kreisförmigen bzw. zylindrischen Bewegungsbahn des Substrathalter-Topfes zyklisch zurück gezogen und wieder vorgeschoben werden. Da bei der Drehung der Substrathalter von Station zu Station die öffnungen der Behandlungsstationen freigegeben werden, entweicht Beschichtungsmaterial in halber Höhe in den Raum zwischen Außen- und Innenkammer und kondensiert auf dort befindlichen Oberflächen, also auch auf den Enden der Schubstangen, deren Führungen und auf die Blattfedern an dem Substrathalter-Topf. Die sich von Arbeitszyklus zu Arbeitszyklus vergrößernde Schichtdicke dieser Kondensate platzt von Zeit zu Zeit in Form von Partikeln ab und führt zu Verunreinigungen, und zwar auch auf der Oberfläche der rotierend geführten Substrate, die dadurch unbrauchbar, also teurer Ausschuß, werden. Besonders schädlich sind hierbei die Abschälvorgänge der Kondensate an den inneren Enden der Schubstangen.

Zwar wird behauptet, daß bei dieser Bau- und Betriebsweise die Verunreinigung der Substrate durch abgeplatzte und von oben kommende Partikel von angesammeltem Schichtmaterial durch Temperaturänderungen vermieden werden soll; dies gilt aber allenfalls für eine absolut senkrechte Stellung der Substratoberflächen auf dem gesamten Transportweg innerhalb der Vakuumkammer. Dies setzt aber eine Befestigung der relativ kleinen Substrate an ihren Haltern voraus.

Durch die FR 2 307 770 A1 ist eine automatische Vorrichtung zum Beschleifen der Ränder von Scheiben aus Hartglas, insbesondere für Fahrzeugscheiben bekannt, zu der auch ein Rotationsantrieb für die Beschickung und Entnahme (evacuation) der Scheiben gehört. Dies geschieht mittels einer Drehsäule, an der vier Schwenkarme mit Saugnäpfen für das Greifen, Aufrichten und Flachlegen der Scheiben und zu deren Ein- und Austragen angeordnet sind. Beidendig drehbar gelagerte Lenkerhebel zum Bewegen der Scheiben in einer zumindest überwiegend horizontalen Richtung gegen Beschichtungsquellen sind nicht offenbart. Der Fachmann erhält auch keine Anregungen, eine solche Vorrichtung zum Vakuumbehandeln, insbesondere zum Beschichten, von Substraten zu verwenden, denn dabei wäre nicht nur die Bildung von Schleifstaub tödlich, sondern Saugnäpfe können auch im Vakuum nicht eingesetzt werden, weil die Druckdifferenz auf beiden Seiten der Saugnapf-Membran um Grössenordnungen zu gering ist, um ein Substrat im Vakuum zu halten oder zu transportieren. Beim Einbringen der Saug-Kombination von Substrat (Scheibe) und Saugnapf in eine Vakuumkammer würde die Druckdifferenz beim Evakuieren der Vakuumkammer zusammenbrechen und das Substrat abfallen, wodurch der Betrieb unterbrochen wird und die Vakuumkammer geöffnet werden müsste.

Durch die EP 0 665 193 B1 und die DE 695 04 716 T2 ist es bei einer Cluster-Anlage zum Zwecke der Begrenzung von Stellfläche und Kammervolumina bekannt, aus Glas bestehende Substrate für großflächige ebene und rechteckige bzw. quadratische Displays mit Abmessungen von 450 mm x 550 mm und darüber hinaus in ständig senkrechter Stellung mittels jeweils eines Substrathalters von der Umgebung in ein System von Vakuumkammern einzuschleusen und mittels des jeweils gleichen Substrathalters zusammen mit diesem wieder an die Umgebung auszuschleusen. Dabei sind zwischen einer zentralen Pufferkammer und den einzelnen Behandlungskammern jeweils Ventiltüren angeordnet. In der Pufferkammer ist konzentrisch und mit vertikaler Achse ein Drehtisch angeordnet, mit dem die Substrate mit ihren Haltern und mit ihren Hauptebenen, also nahezu radial, auf die jeweilige Behandlungskammer ausgerichtet und aus dieser Position in die Behandlungskammern eingefahren und wieder zurückgeholt werden. Der Drehtisch besitzt jedoch keine eigenen Substrathalter. Für den Transport der Substrathalter sind in jeder Behandlungskammer und auf dem Drehtisch voneinander getrennte und getrennt angetriebene Fördereinrichtungen mit Rollen für die Substrathalter angeordnet. Der Bauaufwand und die dafür erforderlichen Antriebs- und Steuereinrichtungen sind beträchtlich; insbesonderen können auf dem Drehtisch auch mehrere, von einander unabhängige Fördereinrichtungen mit Rollen angeordnet sein. Zieht man einen Kreis um die Drehachse des Drehtischs, der auch die radial abstehenden Behandlungskammern einschließt, so ergibt sich ein großer Bedarf an Stellfläche für die komplette Vorrichtung, insbesondere auch deswegen, weil die Substrate "auf einer ihrer Spitzen stehend" in den großflächigen Substrathaltern gehalten sind, so daß die Diagonalmaße der Substrate den Durchmesser des besagten Kreises bestimmen. Das Problem des wiederholten Transports aller Substrathalter zwischen der Umgebung und dem Innern der Anlage mit der Folge des Abplatzens kumulierter Schichten durch Temperaturänderungen in der Anlage ist dadurch nicht beseitigt.

Durch das DE 200 22 564 U1 ist es bekannt, Carrier mit Substraten zu Beschichtungszwecken durch eine erste Schleuse in eine Vakuumanlage einzuschleusen, kontinuierlich auf einer kreisförmigen oder teilkreisförmigen Bahn zu führen und schließlich nach der Beschichtung durch eine zweite Schleuse wieder auszuschleusen. Radialbewegungen oder Bewegungen mit einer radialen Komponente der Carrier innerhalb der Vakuumkammer und gegenüber den Beschichtungsstationen, abweichend von der Kreisbahn, sind nicht vorgesehen. Der Rücktransport der leeren Carrier von der Austragsschleuse zur Eintragsschleuse außerhalb der Vakuumkammer soll auf möglichst kurzen Wege bzw. möglich schnell geschehen, um ein Abplatzen der sich auf den Carriern ansammelnden Schichten innerhalb der Vakuumkammer durch Temperaturschwankungen zu begrenzen.

Durch die DE 102 05 167 C1 ist es bei einer In-Line-Vakuumbeschichtungsanlage bekannt, zwei Pufferkammern mit rotierbaren Wechseleinheiten für Carrier mit Substraten durch zwei lineare Transportwege veränderbarer Länge miteinander zu verbinden, um die Anzahl der Beschichtungsstationen verändern zu können. Die Carrier können dabei in senkrechter oder schwach geneigter Stellung transportiert werden. Der eine Transportweg ist für einen diskontinuierlichen Transport vorgesehen und besitzt an beiden Enden, an die Pufferkammern angrenzend, je eine Schleusenkammer mit zwei Ventilen und davor bzw. danach eine Belade- und eine Entladestation für die Carrier. Der andere Transportweg ist für einen kontinuierlichen Transport vorgesehen und besitzt an beiden Enden, an die Pufferkammern über Ventile angrenzend, je einen Transferbereich für die Carrier, jeweils mit den Substraten. Mittel für eine Carrierbewegung quer zur Transportrichtung innerhalb der Anlage sind nicht vorgesehen und zwar weder auf den linearen Transportwegen, noch in den Pufferkammern, noch in den Transferbereichen. Die Pufferkammern sind lediglich mit Mitteln zum Aufheizen und Abkühlen versehen.

Durch die US 2002/0078892 A1 ist es bekannt, großflächige rechteckige Substrate mit Abmessungen von 1 m x 1,2 m und darüber für LCD-Displays paarweise und senkrecht parallel zueinander oder an den oberen Kanten unter einem spitzen Winkel aufeinander zu geneigt auf unterschiedlichen Transportwegen von Atmosphäre zu Atmosphäre durch Vakuumanlagen - einschließlich Cluster-Anlagen - zu transportieren. Hierzu dienen Substrathalter mit einer waagrechten Platte, auf deren Oberseite in spiegelsymmetrischer Anordnung zwei innen offene Rahmen als Substrathalter angeordnet sind und an deren Unterseite entlang der Symmetrieebene eine Stützplatte mit beiderseitigen Zahnleisten angeordnet ist, mittels welcher der Substrathalter durch Reihen von Ritzeln, die durch Zahnriemen angetrieben werden, in unterschiedlichen und wechselnden Richtungen verfahren werden können.

Als zentrales Teil der Transportvorrichtung dient auch hier wiederum eine rotationssymmetrische Durchgangs- oder Pufferkammer mit einem Drehtisch, auf dessen Unterseite ein solcher Ritzelantrieb mit sechs Ritzeln und einem Motor zur Führung, Änderung der Verschieberichtung und zur Radialverschiebung der Substrathalter angeordnet ist. Auf dem Umfang der Pufferkammer sind - über Absperrventile getrennt - ein Schleusensystem und mindestens drei Behandlungskammern für verschiedene Vakuumprozesse angeordnet. Die Substrathalter werden in radialer Längsrichtung in die Behandlungskammern eingefahren, die infolgedessen entsprechende radiale Abmessungen aufweisen müssen, so daß ein fiktiver Umkreis um die gesamte Anlage einen großen Durchmesser hat, was zu einer entsprechend großen Stellfläche führt. Die Längsverschiebung und entsprechende Antriebe in den Behandlungskammern sind auch deswegen erforderlich, weil solche Behandlungskammern auch in radialen Richtungen aneinander gereiht werden können.

Als Stand der Technik ist in der US 2002/0078892 A1 ein Drehtisch mit einem Transfer-Roboter und zwei Greifern beschrieben, die über Gelenkglieder nach Art eines Scherengelenks in radialer Richtung betätigt werden. Es ist jedoch ausdrücklich angegeben, daß hierbei die Substrate auf dem gesamten Transportweg exzentrisch und in waagrechter Lage gehalten werden, und daß dies bei zunehmenden Abmessungen der Substrate für Displays, z.B. für Wandbildschirme, zu Platz- und Volumensproblemen sowie längeren Pumpzeiten und zum Durchbiegen oder Brechen der nur 0,7 mm dicken Substrate unter ihrem Eigengewicht führt. Dabei ergibt eine Vergrößerung der waagrechten Dimensionen der Substrate den doppelten Wert der Durchmesser-Vergrößerung, z.B. über 2 m, hinaus, was mit zusätzlichen Vergrößerungen der Schleusenventile und mit Masseproblemen beim Beschleunigen und Verzögern und mit Toleranzproblemen verbunden ist.

In der US 2002/0078892 A1 ist ferner angegeben, daß die Stützplatte des Drehtischs mittels eines magnetischen Hubantriebs von einer Führungsschiene abgehoben werden kann, um eine Staubentwicklung durch Abrieb zu vermeiden. Das Problem einer Vermeidung der Staubbildung durch Abplatzen von kumulativ auf den Substrathaltern angesammeltem Schichtmaterial durch den Transport von Atmosphäre zu Atmosphäre und Erwärmen innerhalb der Vakuumkammern, sowie durch Abrieb von den Ritzelantrieben ist jedoch nicht angesprochen. Ein weiterer wesentlicher Nachteil der bekannten Anordnung ist jedoch der, daß mit der Zahl der an die Zentral- oder Pufferkammer angeschlossenen Behandlungskammern die Zahl der kammerinternen Transportmechanismen wächst, die zu dem Transportmechanismus des Drehtisches in der Pufferkammer kompatibel sein müssen, damit eine übergabe in die und aus den Behandlungskammern überhaupt möglich ist.

Anhand des vorstehenden Standes der Technik wurde aufgezeigt, daß durch die laufende Vergrößerung der Substratabmessungen und die Verringerung der Formsteifigkeit und -festigkeit durch Verringerung der Substratdicke mit Fortschreiten der Entwicklung neue Probleme entstanden sind, die zu sehr komplexen und aufwändigen Bauprinzipien und komplizierten Betriebsabläufen geführt haben, und daß es trotzdem nicht gelungen ist, das Stellflächenproblem und das Problem der Verunreinigung der Substrate durch Partikel von kumulierten Schichten auf Anlagenkomponenten zufriedenstellend zu lösen.

Der Erfindung liegt daher die Aufgabe zugrunde, Bauprinzipien und Betriebsabläufe anzugeben, die zu einer weiteren Verringerung der Stellfläche, der Kammervolumina, der Evakuierungszeiten und zu einer weiteren Vereinfachung des "Handlings" der Substrate außerhalb und innerhalb der Vakuumkammer und trotzdem insbesondere zu einer deutlichen Verringerung der Verunreinigungsgefahr der Substrate durch Partikel abgeplatzter Schichtpakete führen.

Die Lösung der gestellten Aufgabe erfolgt dabei erfindungsgemäß durch die Merkmale im Kennzeichen des Patentanspruchs 1, nämlich dadurch, daß die Substrathalter in ihren unteren Bereichen über Lenkeranordnungen mit dem Antriebsmechanismus verbunden sind und daß zumindest die unteren Schwenklager der Lenkeranordnungen unterhalb einer waagrechten Mittellinie der Höhe der tragenden Fläche der Substrathalter angeordnet sind.

Durch diese Lösung wird die gestellte Gesamtaufgabe in vollem Umfange zufriedenstellend gelöst, insbesondere werden Bauprinzipien und Betriebsabläufe angegeben, die zu einer weiteren Verringerung der Stellfläche, der Kammervolumina, der Evakuierungszeiten und zu einer weiteren Vereinfachung des "Handlings" der Substrate außerhalb und innerhalb der Vakuumkammer und trotzdem insbesondere zu einer deutlichen Verringerung der Verunreinigungsgefahr der Substrate durch Partikel abgeplatzter Schichtpakete führen. Der konstruktive Aufwand und der Ausschuß werden verringert und die Produktqualität wird beträchtlich gesteigert.

Es ist im Zuge weiterer Ausgestaltungen der Erfindung besonders vorteilhaft, wenn - entweder einzeln oder in Kombination:
* alle Schwenklager der Lenkeranordnungen unterhalb der waagrechten Mittellinie der Höhe der tragenden Fläche der Substrathalter angeordnet sind,
* der Antriebsmechanismus für jeden Substrathalter paarweise angeordnete Ausleger besitzt, an denen jeweils eine ParallelogrammLenkeranordnung hängend angeordnet ist,
* die unteren Schwenklager der Parallelogramm-Lenkeranordnungen jeweils an einem U-förmigen Bügel angeordnet sind, dessen nach außen gerichtete Schenkel mit einer Traverse verbunden sind, die den unteren Abschluß des jeweiligen Substrathalters bildet,
* der Antriebsmechanismus einen Drehteller besitzt, auf den für jeden Substrathalter eine Gruppe von Trapez-Lenkeranordnungen aufgestellt ist,
* der Antriebsmechanismus ein Dreh- und Hubantrieb mit einer konzentrischen Welle ist, durch deren Vertikalbewegung die Trapez-Lenkeranordnungen mit Radialbewegungen auf die Substrathalter zur Einwirkung bringbar sind,
* die Vakuumkammer
   a) ein topfförmiges, rotationssymmetrisches und stationäres inneres Kammerteil mit einer vertikalen Achse und einem ersten Boden besitzt,
   b) ein äußeres, das innere Kammerteil mit Abstand umgebendes Kammerteil besitzt, zwischen denen ein ringförmiger Raum für die Rotation der Substrathalter angeordnet ist, wobei das äußere Kammerteil mit mehreren, in gleichem Winkelabstand angeordnete öffnungen und daran angeschlossene Behandlungskammern versehen ist und einen weiteren Boden besitzt, der stationär und mit Abstand unterhalb des ersten Bodens angeordnet ist,
   c) für die synchrone Radialbewegung der Substrathalter relativ zu den öffnungen der Behandlungskammern mindestens eine Lenkeranordnung aufweist, die um die Achse drehbar zwischen dem ersten Boden und dem zweiten Boden angeordnet ist, und schließlich
   d) eine Schleusenreihe mit einer übergabekammer für die sukzessive Beschickung der Anlage mit rahmenlos geführten Substraten besitzt.
* die lineare, fluchtende Schleusenreihe in tangentialer Ausrichtung zur Vakuumkammer angeordnet ist und eine Eintragsschleuse, eine übergabekammer und eine Austragsschleuse mit zwischengeschalteten Vakuumventilen enthält, wobei die Schleusenreihe einen linearen Transportweg der Substrate vor und nach der Vakuumbehandlung definiert,
* die um die senkrechte Achse drehbaren Substrathalter nach oben hin um einen Winkel zwischen 1 und 20 Grad gegen die Achse geneigt angeordnet sind, insbesondere, wenn die um die senkrechte Achse drehbaren Substrathalter nach oben hin um einen Winkel zwischen 3 und 15 Grad gegen die Achse geneigt angeordnet sind.
* sich für die rahmenlose Führung der Substrate in den Schleusenkammern stationäre Substrathalter befinden, die unter den gleichen Winkeln zur Senkrechten stehen wie die drehbaren Substrathalter (13),
* die Substrathalter an ihren unteren Enden Rollen für die Aufnahme und Weitergabe der Substrate und darüber öffnungen für den Austritt von Gasen zur Ausbildung von Gaskissen zum reibungsfreien Transport der Substrate während ihrer Relativbewegung zum jeweiligen Substrathalter aufweisen,
* die öffnungen der Behandlungskammern in bezug auf die ihnen gegenüber stehenden drehbaren Substrathalter Ränder aufweisen, die in einer zur Ebene der Substrathalter parallelen Ebene liegen,
* die öffnungen der Behandlungskammern mit Blenden zur Maskierung der Substrate während der Behandlung versehen sind,
* die Lenkeranordnungen für den Vorschub der drehbaren Substrathalter ausschließlich Gelenke besitzen, mit denen die Substrathalter ohne Auftreten von linearen Gleitreibungen bewegbar sind,
* die kürzesten und oberen Glieder der Trapez-Lenkeranordnungen in ihrer Mitte weitere Gelenke besitzen, und wenn jeweil zwei in Reihe geschaltete Trapez-Lenkeranordnungen mittels Distanzlenkern derart miteinander verbunden sind, daß die in Reihe geschalteten Trapez-Lenkeranordnungen jeweils gleiche Winkelstellungen einnehmen
* der Antriebsmechanismus für die Welle in dem inneren, zur Atmosphäre hin offenen Kammerteil angeordnet ist,
* die oberen Glieder der Trapez-Lenkeranordnungen fest angebrachte weitere Lenker besitzen, deren untere Enden über Gelenke mit Auslegern verbunden sind, an deren äußeren Enden die Substrathalter befestigt sind,
* die oberen Glieder und deren Lenker die Form eines "T" aufweisen, insbesondere, wenn
* an der Welle ein Tragflansch angeordnet ist, der über Lenker auf Winkelhebel einwirkt, die auf dem Drehteller gelagert sind und deren einer Schenkel ein Teil der jeweils innersten Trapez-Lenkeranordnungen ist und durch den ein Verschwenken der Trapez-Lenkeranordnungen herbeiführbar ist.

Zwei Ausführungsbeispiele des Erfindungsgegenstandes und ihre Wirkungsweisen werden nachfolgend anhand der Figuren 1 bis 10 näher erläutert.

Es zeigen:
- Figur 1: eine perspektivische Darstellung des inneren Antriebsmechanismus mit zwei Substratträgern in radial eingezogener Stellung,
- Figur 2: eine perspektivische Darstellung des inneren Antriebsmechanismus analog Figur 1, jedoch mit zwei Substratträgern in radial ausgefahrener Stellung,
- Figur 3: einen teilweisen vertikalen Radialschnitt durch eine Vakuumanlage mit einem Antriebsmechanismus in der Stellung nach Figur 1,
- Figur 4: einen teilweisen vertikalen Radialschnitt durch eine Vakuumanlage mit einem Antriebsmechanismus in der Stellung nach Figur 2,
- Figur 5: einen vergrößerten Ausschnitt aus dem Antriebsmechanismus gemäß Figur 4,
- Figur 6: eine schematische Darstellung der überlagerten Bewegungsabläufe in Umfangsrichtung und in radialen Richtungen,
- Figur 7: eine perspektivische Außenansicht einer vollständigen Anlage mit den Mitteln nach den Figuren 1 bis 6,
- Figur 8: eine Variante des Gegenstandes nach den Figuren 1 bis 7 mit eingezogenen Substrathaltern analog Figur 3,
- Figur 9: den Gegenstannd von Figur 8 mit ausgefahreren Substrathaltern analog Figur 4 und
- Figur 10: einen Vergleich von Ausschnitten aus den Figuren 8 und 9,

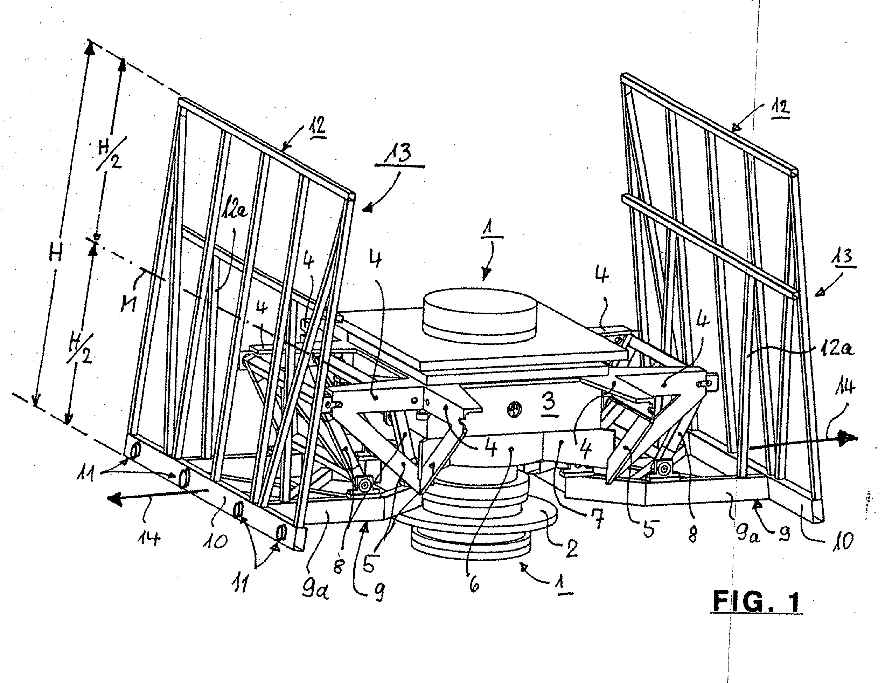

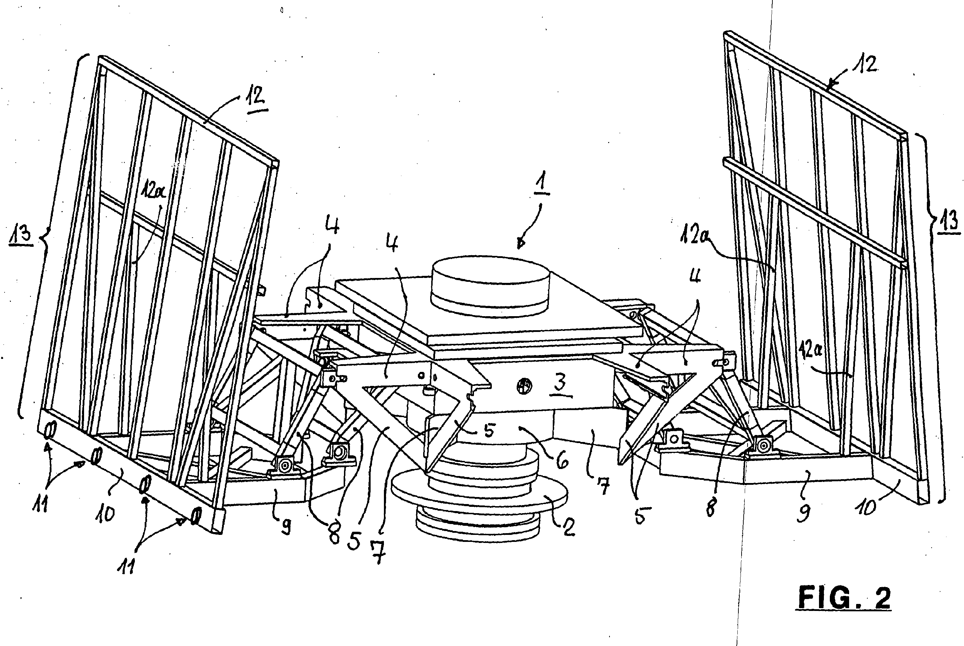

In den Figuren 1 und 2 ist ein zentraler Antriebsmechanismus 1 mit senkrechter Achse und einem koaxialen Montageflansch 2 für die Befestigung an einem hier nicht gezeigten unteren Boden der Vakuumkammer dargestellt. Dieser Antriebsmechanismus 1 trägt in seinem oberen Bereich eine drehbare Kammer 3 mit quadratischem Grundriß, an deren Ecken insgesamt acht Ausleger 4 befestigt sind, die sich über Schrägstreben 5 an einem zylindrischen Unterbau 6 der Kammer 3 abstützen, und zwar jeweils paarweise zusammengeführt über vier radial abstehende Ausleger 7 (siehe hierzu Figur 2).

An den Auslegern 4, die paarweise parallel zueinander verlaufen und ein rechtwinkliges Kreuz bilden, hängen über obere, feste Schwenklager insgesamt acht Parallelogramm-Lenkeranordnungen 8 nach unten. Die unteren Enden der Parallelogramm-Lenkeranordnungen 8 sind schwenkbar an waagrechten U-förmigen Bügeln 9 mit paarweise zueinander parallelen Schenkeln 9a gelagert, deren nach außengerichtete Enden durch je eine Traverse 10 verbunden sind. Jede der Traversen trägt mindestens zwei vorstehende Rollen 11, die als Auflagen für hier nicht gezeigte Substrate dienen und ggf. antreibbar und/oder arretierbar sind. Nach oben hin trägt jede der Traversen 10 ein schräg nach oben und hinten unter einem Winkel zwischen 3 und 15 Grad zur Senkrechten ausgerichtetes Rahmengestell 12 mit Längs- und Querstreben nach Art eines Fachwerks, das über senkrechte Stützen 12a auf dem jeweiligen Bügel 9 abgestützt ist.

Die Außenseiten der Traversen 10 und des Rahmengestells 12 liegen in einer gemeinsamen Ebene, deren Umriß zumindest im wesentlichen dem Umriß des jeweiligen Substrats entspricht. Dadurch bilden diese Teile jeweils einen formsteifen Substrathalter 13. Diese besitzen in Richtung ihrer besagten Ebenen eine Höhe "H" und definieren in deren Mitte (H/2) eine waagrechte virtuelle Mittellinie "M", unterhalb welcher alle Lenkeranordnungen und ihre Schwenkgelenke angeordnet sind

Die beiden gezeigten Substrathalter 13 sind dadurch in Richtung der Pfeile 14 entgegengesetzt und im wesentlichen radial zueinander bewegbar. Es ist zu betonen, daß nur zwei der Substrathalter 13 gezeigt sind. Die beiden übrigen Substrathalter, die vor und hinter dem Antriebsmechanismus 1 angeordnet sind, sind der übersichtlichkeit halber nicht dargestellt. Sie sind gleichfalls in entgegengesetzten Richtungen radial beweglich, und zwar im rechten Winkel zu den beiden Pfeilen 14. Die Rahmengestelle 12 sind an zahlreichen Stellen perforiert und an eine nicht gezeigte Gasquelle angeschlossen, so daß die Substrate in der Beschickungsstellung nach Art eines "Luftkissenfahrzeugs" reibungsfrei und formwahrend auf den jeweiligen Substrathalter 13, durch die Rollen 11 geführt, aufgeschoben werden können. Danach wird die Gaszufuhr unterbrochen, um die Gasatmosphären in den einzelnen Behandlungskammern nicht zu beeinträchtigen.

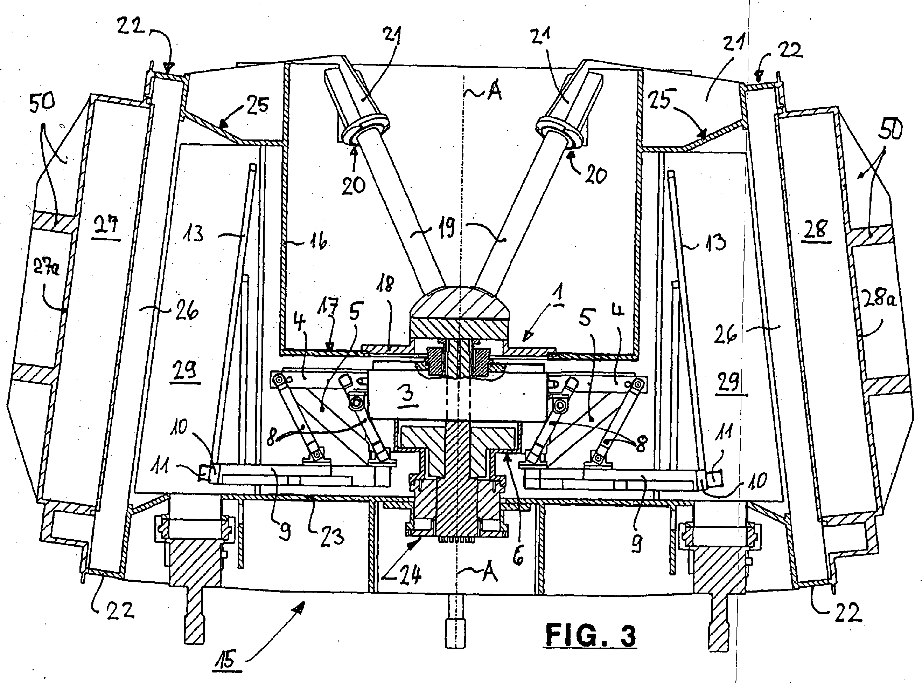

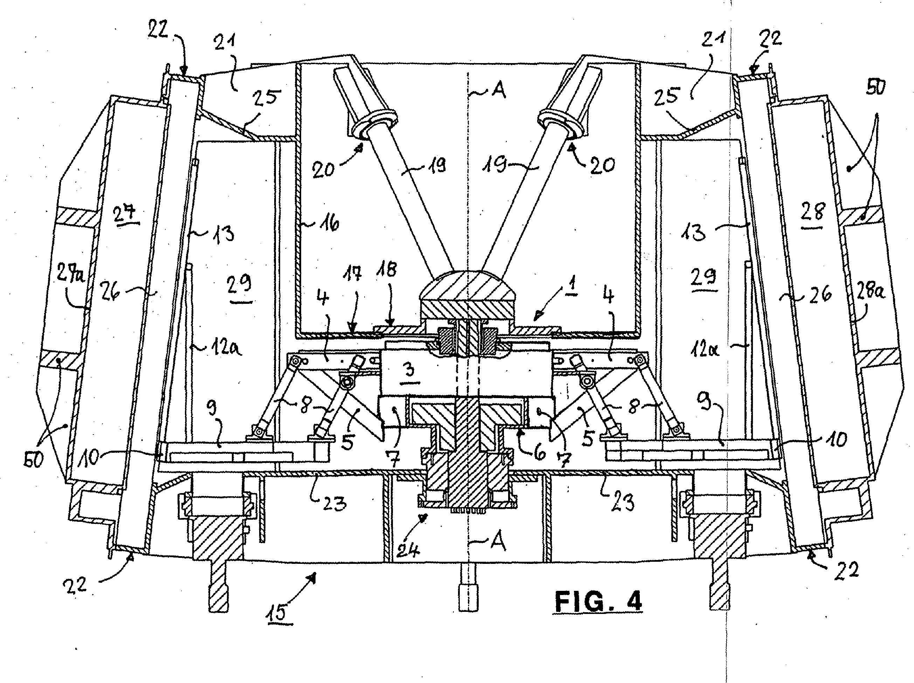

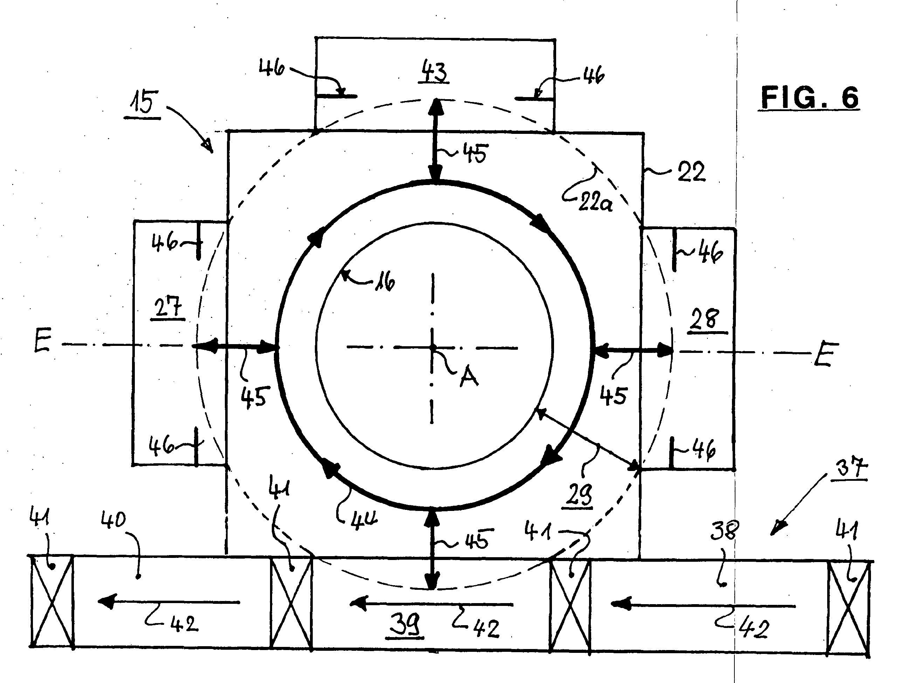

Die Figuren 3 und 4 zeigen das Rotationssystem nach den Figuren 1 und 2 integriert in eine Vakuumkammer 15 mit einer vertikalen Achse A-A. Die Vakuumkammer 15 besteht aus einem inneren, topfförmigen Kammerteil 16 mit einem Boden 17, in dem der obere Endbereich des Antriebsmechanismus 1 mittels eines Flansches 18 vakuumdicht eingesetzt ist. Die vertikale Abstützung erfolgt über vier Ankerstreben 19, deren wirksame Länge über Einstellelemente 20 veränderbar ist. Hiervon sind nur die beiden hinter der vertikalen Schnittebene (E-E in Figur 6) liegenden Einstellelemente 20 gezeigt, die an radialen Knotenblechen 21 aufgehängt sind.

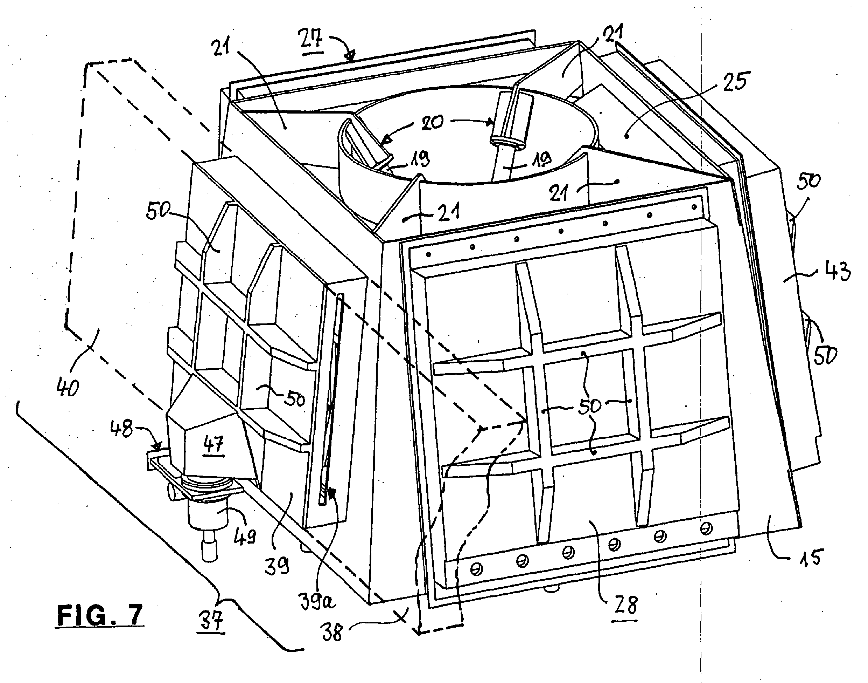

Die Vakuumkammer 15 besitzt weiterhin einen äußeren Kammerteil 22 in Form eines vierkantigen Pyramidenstumpfes mit einem Boden 23, durch den der untere Endbereich 24 des Antriebsmechanismus 1 vakuumdicht hindurchgeführt ist. Der innere und der äußere Kammerteil 16 bzw. 22 sind durch eine Decke 25 vakuumdicht miteinander verbunden. Die Wände des äußeren Kammerteils 22 sind in äquidistanter Verteilung mit vier rechteckigen öffnungen 26 versehen, von denen hier gleichfalls nur zwei diametral gegenüberliegende öffnungen 26 sichtbar sind. Auf die öffnungen 26 sind Behandlungskammern 27 und 28 aufgesetzt, die mit nicht gezeigten Einrichtungen für die unterschiedlichsten Vakuumprozesse ausgestattet werden können. Die Außenwände 27a und 28a der Behandlungskammern 27 und 28 sind mit Verrippungen 50 für die Aufnahme der Kräfte des atmosphärischen Drucks versehen (insb. Figur 7).

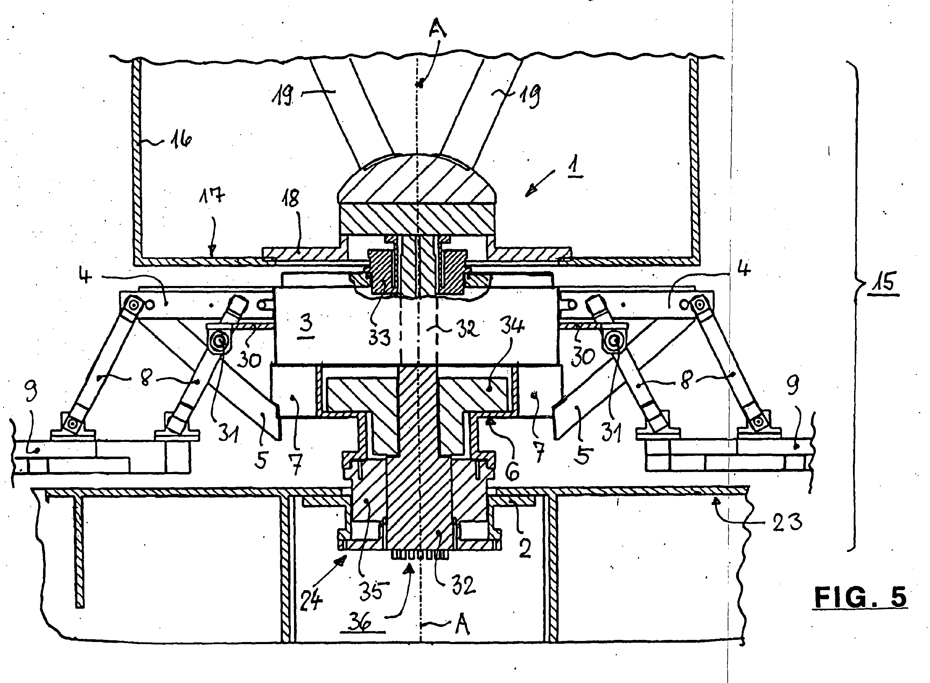

Zwischen den waagrechten Böden 17 und 23 befinden sich die wesentlichen drehbaren Teile des Antriebsmechanismus 1, der anhand der Figur 5 noch näher erläutert werden wird. In den ringförmigen Raum 29 zwischen den inneren und den äußeren Kammerteilen 16 bzw. 22 ragen von unten nach oben die drehbaren und mit radialen Komponenten verschiebbaren Substrathalter 13. Schiebedurchführungen durch die zylindrische Wand des inneren Kammerteils 16 sind nicht vorhanden. Die Verlagerungen der Substrathalter 13 aus der Stellung nach Figur 3 in diejenige nach Figur 4 erfolgen vielmehr durch die bereits beschriebenen Parallelogramm-Lenkeranordnungen 8, bei den sich die Raumlage der Schwenklager bereits aus der Definition "Parallelogramm Lenkeranordnungen" ergibt. Es sei nur soviel gesagt, daß sich die Tiefstpunkte der unteren Schwenklager unterhalb des entsprechenden oberen Schwenklagers des jeweils gleichen Lenkers befinden. Es erfolgt also eine symmetrische Verschwenkung um eine Mittellage. Durch eine ausreichende Bemessung der Länge der Lenker bei vorgegebener Bemessung des Schwenkwinkels bzw. der radialen Bewegungskomponente läßt sich erreichen, das die vertikale Bewegungskomponente kleinstmöglich wird. Solche Schwenklager erzeugen im Gegensatz zu Schiebe-Durchführungen praktisch keinen Abrieb und auch keinen Staub von Beschichtungsmaterial, der die Schichtqualitäten auf den Substraten beeinflussen könnte. Hinzu kommt, daß der Angriff der U-förmigen Bügel 9 an den Substrathaltern 13 an deren Unterkanten erfolgt und nicht in Substratmitte wie bei dem Gegenstand der EP 0 136 562 B1. Die unteren Schwenklager der bereits beschriebenen Parallelogramm-Lenkeranordnungen 8 liegen nur mit geringstmöglichem Abstand über den Oberseiten der Bügel 9 und auf den Rückseiten der Substrathalter 13, so daß etwaiger Abrieb auch aus diesem Grund die Außenseiten der Substrate nicht erreichen kann.

Figur 5 zeigt nun einen vergrößerten Ausschnitt aus dem Antriebsmechanismus 1 in seiner Stellung gemäß Figur 4. Es werden die bisherigen Bezugszeichen verwendet und fortgeschrieben. In der drehbaren Kammer 3 sind ein Antriebsmotor für die schrittweise Drehbewegung sowie waagrechte Steuerstangen 30 für die zyklischen Bewegungen der bereits beschriebenen Parallelogramm-Lenkeranordnungen 8 angeordnet, wobei die Steuerstangen 30, die im Innern der Kammer 3 geführt und angetrieben sind, mit ihren äußeren Enden aus der Kammer 3 herausragen und an den jeweils inneren Lenkern über Schwenklager 31 angreifen.

Der Antriebsmechanismus 1 besitzt eine koaxiale, durch die Böden 17 und 23 hindurchgehende Welle 32, die mittels einer ersten vakuumdichten Drehdurchführung 33 durch den oberen Boden 17 und mittels einer zweiten vakuumdichten Drehdurchführung 34 und durch ein Radiallager 35 durch den unteren Boden 23 hindurch geführt ist. Eine Gruppe von Anschlußstutzen 36 dient zur Zuführung von Behandlungsmedien und - soweit erforderlich - auch zur Stromzuführung.

Die Figur 6 zeigt nun eine schematische Darstellung der überlagerten Bewegungsabläufe in Umfangsrichtung und in radialer Richtung. Parallel zum äußeren Kammerteil 22, der auch nach Art eines Kegelstumpfes gemäß des gestrichelten Kreises 22a ausgebildet sein kann, verläuft parallel zu einer Tangente an die Vakuumkammer 15 eine Schleusenreihe 37, die aus eine Eintragsschleuse 38 einer übergabekammer 39 und einer Austragsschleuse 40 besteht. Die Schleusenreihe 37 enthält Vakuumventile 41 bekannter Bauart. Die Linie E-E steht für die vertikale Schnittebene der Figuren 3 und 4.

Die lineare schrittweise Transportrichtung der schräg stehenden bzw. geführten Substrate ohne Substrathalter durch die Schleusenreihe 37 ist durch die Reihe der Pfeile 42 angedeutet. Der übergabekammer 39 liegt eine weitere Behandlungskammer 43 gegenüber. Im Innern des ringförmigen Raumes 29 sind die Bewegungsfolgen durch dicke Pfeillinen angedeutet. Die schrittweise Drehbewegung erfolgt - von der übergabekammer 39 ausgehend - um jeweils 90 Grad entlang der geschlossenen Pfeillinie 44. An den vier Haltepunkten jeweils unmittelbar vor der übergabekammer 39 und den Behandlungskammern 27, 43 und 28 sind durch radiale Doppelpfeile 45 Vorschub und Rückzug der Substrate angedeutet. Der Vorschub der Substrate erfolgt bis unmittelbar vor abschirmende rahmenförmige Blenden 46, die in den öffnungsbereichen der Behandlungskammern 27, 43 und 28 angeordnet sind. Eine abdichtenden Wirkung zwischen den Substraten und diesen Blenden 46 ist jedoch nicht erforderlich, schon weil die äußerst dünnen Substrate hierfür keinen Beitrag leisten können oder müssen. Sobald die Rückwärtsbewegungen der Substrathalter vollendet sind, werden diese um 90 Grad vor die jeweils nächste Behandlungskammer gedreht, am Ende der Behandlung vor die übergabekammer 39 zum Weitertransport in die Austragsschleuse 40.

Die Figur 7 zeigt nun eine perspektivische Außenansicht einer vollständigen Anlage mit den Mitteln und den Bezugszeichen nach den Figuren 1 bis 6. Beiderseits der übergabekammer 39 sind die Eintragsschleuse 38 und die Austragsschleuse 40 gestrichelt angedeutet. Von der Übergabekammer 39 ist der schräg stehende Eintrittsschlitz 39a gezeigt, desgleichen ein daran angeschlossener Pumpstutzen 47 mit einem Absperrschieber 48 und einer Kryopumpe 49. Deutlich sichtbar sind die Verrippungen 50 der der übergabekammer 39 und der Behandlungskammer 28 gegen den Atmosphärendruck.

Speziell aus den Figuren 6 und 7 geht die äußerst kompakte, Raum und Volumen sparende Ausbildung der Anlage hervor, insbesondere die Tatsache, daß die Substrathalter nicht an die Atmosphäre ausgeschleust werden müssen. In allen Fällen sind auch in den Schleusenkammern 38 und 40 perforierte Substrathalter mit Druckgasversorgung über die gesamte Substratfläche und Rollen am unteren Ende angeordnet, so daß die Substrate reibungsfrei über Gaspolstern auf die Substrathalter aufgeschoben und wieder abgeschoben werden können. Zum Evakuieren und beim Stillstand der Substrate auf ihren Haltern werden die Gasversorgungen vorübergehend abgestellt. Dies gilt auch für die Zeitspanne, in der sich die Substrate auf ihren Substrathaltern in der Vakuumkammer 15 befinden. Dies gilt auch für das nachfolgende Ausführungsbeispiel.

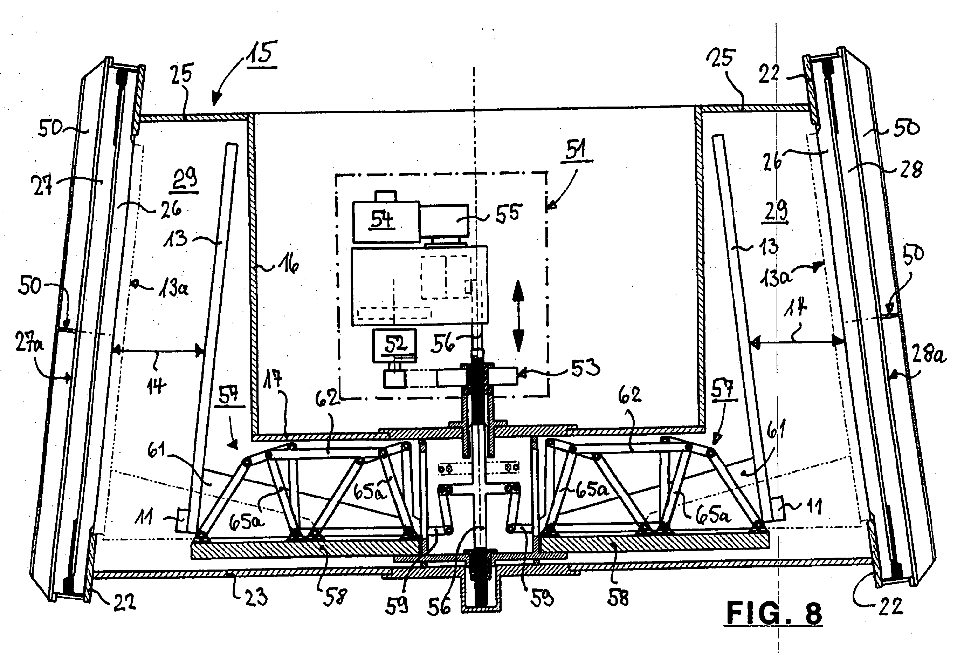

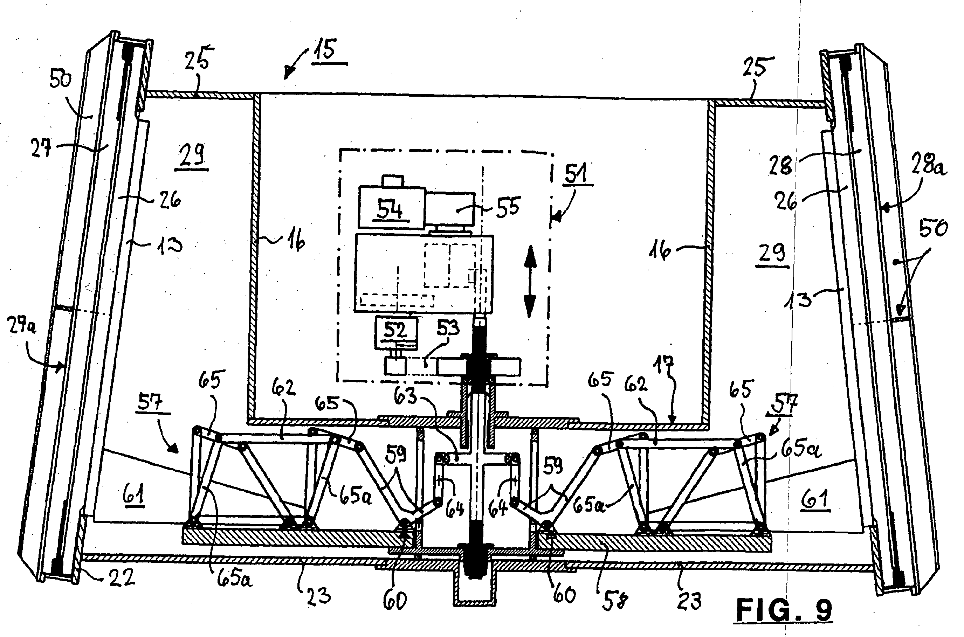

Die Figuren 8 und 9 zeigen nun eine Variante des Gegenstandes nach den Figuren 1 bis 7 unter Fortschreibung der bisherigen Bezugszeichen. Unterschiedlich ist hier der Rotations- und Vorschubantrieb für die Substrathalter 13. In dem topfförmigen inneren Kammerteil 16 mit dem Boden 17 ist hier ein Dreh- und Hubantrieb 51 angeordnet, der einen ersten Motor 52 mit einem Untersetzungsgetriebe 53 zur Erzeugung einer Rotationsbewegung und einen zweiten Motor 54 mit einem Untersetzungsgetriebe 55 zur Erzeugung einer Hub- und Senkbewegung einer gemeinsamen Welle 56 aufweist. Vier doppelte Trapez-Lenkeranordnungen 57 sind auf einem Drehteller 58 angeordnet, der durch die Welle 56 schrittweise in Rotation versetzbar ist. Die Substrathalter 13 sind in Figur 8 mit durchgehenden Linien in ihren eingezogenen Stellungen dargestellt.

Durch Anheben der Welle 56, die einen Tragflansch 63 besitzt, werden über daran aufgehängte und nahezu senkrechte Lenker 64 (Figur 9) vier Winkelhebel 59 um ihre Festlager 60 nach außen verschwenkt, wodurch die Trapez-Lenkeranordnungen 57 an ihren oberen Enden nach außen verschwenkt werden, wie dies in Figur 9 dargestellt ist. Die am weitesten oben liegenden und kürzesten Glieder 65 der Trapez-Lenkeranordnungen 57 sind T-förmig ausgebildet und in ihren Mitten mit weiteren Gelenken versehen, wobei jeweils zwei in Reihe geschaltete Trapez-Lenkeranordnungen 57 durch waagrechte Distanzlenker 62 derart miteinander verbunden sind, daß die in Reihe geschalteten Trapez-Lenkeranordnungen 57 jeweils gleiche Winkelstellungen zum Drehteller 58 einnehmen. Die T-förmige Ausbildung der Glieder 65 erfolgt durch eine Verbindung mit weiteren, drehfest angesetzten Lenkern 65a, deren untere Enden über Paare von nicht besonders hervorgehobenen Schwenklagern mit den waagrechten Unterkanten von keilförmigen Auslegern 61 verbunden sind, die an den unteren Enden der Substrathalter 13 angeordnet sind. Dieser Bewegung, die durch die Winkelhebel 59 erzwungen wird, folgen synchron alle anderen Trapez-Lenkeranordnungen 57.

Mitgezogen werden dadurch die Ausleger 61 und die daran schräg stehend befestigten Substrathalter 13. Dabei ist die Auslegung der Trapez-Lenkeranordnungen 57 so getroffen, daß eine Vertikalkomponente der Radialbewegung kleinstmöglich ist. Am Ende der Radialbewegung nehmen die Substrathalter 13 die in Figur 8 strichpunktierten Stellungen 13a gegenüber den Behandlungskammern 27 und 28 ein. Gleiches gilt für die Stellungen der Substrathalter 13 gegenüber der weiteren Behandlungskammer und der übergabekammer, die hier der Einfachheit halber weggelassen sind. Die Radial äußere Endstellung der Substrathalter 13 ist in Figur 9 mittels durchgehender Linien gezeigt.

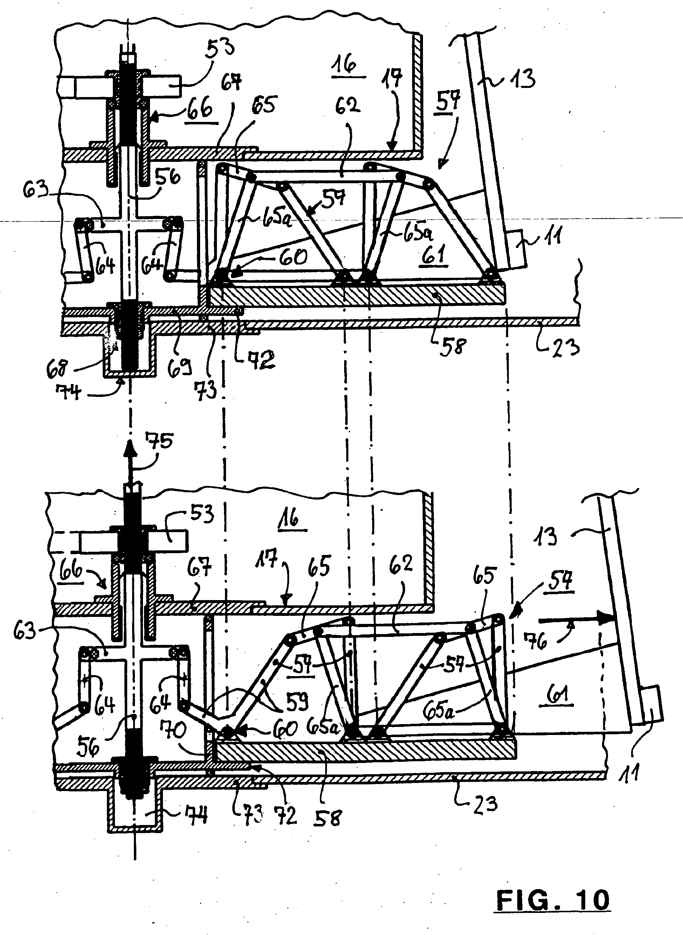

Anhand der Figur 10 werden die Figuren 8 und 9 unter Verwendung der bisherigen Bezugszeichen und deren Fortschreibung miteinander verglichen: Die Welle 56 ist mittels einer Kombination 66 aus einem oberen Drehlager und einer Vakuumdurchführung mittels einer drehfesten kreisscheibenförmigen Tragplatte 67 durch den Boden 17 des inneren Kammerteils 16 hindurchgeführt. Das untere Ende der Welle 56 ist axial verschiebbar in einem unteren Drehlager 68 geführt, das seinerseits in einer weiteren Drehscheibe 69 gelagert ist, die nach oben hin einen zylindrischen Aufsatz 70 mit Durchbrechungen 71 und einen radialen Flansch 72 trägt, auf den der Drehteller 58 mit den Trapez-Lenkeranordnungen 57 aufgesetzt ist. Die Abdichtung nach unten hin erfolgt durch eine ortsfeste Tragplatte 73, die vakuumdicht in den Boden 23 des äußeren Kammerteils 22 eingesetzt und unter dem Ende der Welle 56 mit einem topfförmigen Fortsatz 74 für die Absenkung der Welle 56 versehen ist.

Es ist deutlich erkennbar, daß durch den Hub der Welle 56 in Richtung des Pfeils 75 die gesamten Trapez-Lenkeranordnungen 57 und damit die Substrathalter 13 über die Winkelhebel 59 und die Distanzlenker 62 in Richtung des Pfeils 76 synchron verschiebbar sind, da die Ausleger 61 an den unteren Enden der mit den Gliedern 65 fest verbundenen Lenker 65a gelenkig gelagert sind.

### Bezugszeichenliste:

- 1: Antriebsmechanismus
- 2: Montageflansch
- 3: Kammer
- 4: Ausleger
- 5: Schrägstreben
- 6: Unterbau
- 7: Ausleger
- 8: Parallelogramm-Lenkeranordnungen
- 9: Bügel
- 10: Traverse
- 11: Rollen
- 12: Rahmengestell
- 12a: Stützen
- 13: Substrathalter
- 13a: Stellungen
- 14: Pfeile
- 15: Vakuumkammer
- 16: Kammerteil
- 17: Boden
- 18: Flansch
- 19: Ankerstreben
- 20: Einstellelemente
- 21: Knotenbleche
- 22: Kammerteil
- 22a: Kreis
- 23: Boden
- 24: Endbereich
- 25: Decke
- 26: öffnungen
- 27: Behandlungskammer
- 27a: Außenwand
- 28: Behandlungskammer
- 28a: Außenwand
- 29: Raum
- 30: Steuerstangen
- 31: Schwenklager
- 32: Welle
- 33: Drehdurchführung
- 34: Drehdurchführung
- 35: Radiallager
- 36: Anschlußstutzen
- 37: Schleusenreihe
- 38: Eintragsschleuse
- 39: übergabekammer
- 39a: Eintrittsschlitz
- 40: Austragsschleuse
- 41: Vakuumventile
- 42: Pfeile
- 43: Behandlungskammer
- 44: Pfeillinie
- 45: Doppelpfeile
- 46: Blenden
- 47: Pumpstutzen
- 48: Absperrschieber
- 49: Kryopumpe
- 50: Verrippungen
- 51: Dreh- und Hubantrieb
- 52: Motor
- 53: Untersetzungsgetriebe
- 54: Motor
- 55: Untersetzungsgetriebe
- 56: Welle
- 57: Trapez-Lenkeranordnungen
- 58: Drehteller
- 59: Winkelhebel
- 60: Festlager
- 61: Ausleger
- 62: Distanzlenker
- 63: Tragflansch
- 64: Lenker
- 65: Glieder
- 65a: Lenker
- 66: Kombination
- 67: Tragplatte
- 68: Drehlager
- 69: Drehscheibe
- 70: Aufsatz
- 71: Durchbrechungen
- 72: Flansch
- 73: Tragplatte
- 74: Fortsatz
- 75: Pfeil
- 76: Pfeil

- A-A: Achse
- E-E: Linie/Schnittebene
- H: Höhe
- M: Mittelline

## Patentansprüche

1. Vakuum-Behandlungsanlage für ebene rechteckige bzw. quadratische Substrate in einer zumindest im wesentlichen senkrechten Stellung, enthaltend eine Vakuumkammer (15) mit mindestens zwei auf den Umfang der Vakuumkammer (15) verteilten kammerseitig offenen Behandlungskammern (27, 28, 43), eine Eintragsschleuse (38), eine Austragsschleuse (40) und eine drehbare Anordnung von Substrathaltern (13) innerhalb der Vakuumkammer (15) mit einem Antriebsmechanismus (1, 51) für die sequentielle Rotation und den Vorschub und Rückzug der Substrathalter (13) relativ zu den Behandlungskammern (27, 28, 43), **dadurch gekennzeichnet, daß** die Substrathalter (13) in ihren unteren Bereichen über Lenkeranordnungen (8, 57) mit dem Antriebsmechanismus (1, 51) verbunden sind und daß zumindest die unteren Schwenklager der Lenkeranordnungen (8, 57) unterhalb einer waagrechten Mittellinie (M) der Höhe (H) der tragenden Fläche der Substrathalter (13) angeordnet sind.

2. Vakuum-Behandlungsanlage nach Anspruch 1, **dadurch gekennzeichnet, daß** alle Schwenklager der Lenkeranordnungen (8, 57) unterhalb der waagrechten Mittellinie (M) der Höhe (H) der tragenden Fläche der Substrathalter (13) angeordnet sind.

3. Vakuum-Behandlungsanlage nach Anspruch 1, **dadurch gekennzeichnet, daß** der Antriebsmechanismus (1) für jeden Substrathalter (13) paarweise angeordnete Ausleger (4) besitzt, an denen jeweils eine Parallelogramm-Lenkeranordnung (8) hängend angeordnet ist.

4. Vakuum-Behandlungsanlage nach Anspruch 3, **dadurch gekennzeichnet, daß** die unteren Schwenklager der Parallelogramm-Lenkeranordnungen jeweils an einem U-förmigen Bügel (9) angeordnet sind, dessen nach außen gerichtete Schenkel (9a) mit einer Traverse (10) verbunden sind, die den unteren Abschluß des jeweiligen Substrathalters (13) bildet.

5. Vakuum-Behandlungsanlage nach den Ansprüchen 1 und 2, **dadurch gekennzeichnet, daß** der Antriebsmechanismus (51) einen Drehteller (58) besitzt, auf den für jeden Substrathalter (13) eine Gruppe von Trapez-Lenkeranordnungen (57) aufgestellt ist.

6. Vakuum-Behandlungsanlage nach Anspruch 5, **dadurch gekennzeichnet, daß** der Antriebsmechanismus (51) ein Dreh- und Hubantrieb mit einer konzentrischen Welle (56) ist, durch deren Vertikalbewegung die Trapez-Lenkeranordnungen (57) mit Radialbewegungen auf die Substrathalter (13) zur Einwirkung bringbar sind.

7. Vakuum-Behandlungsanlage nach mindestens einem der Ansprüche 1 bis 6, **dadurch gekennzeichnet, daß** die Vakuumkammer (15)
a) ein topfförmiges, rotationssymmetrisches und stationäres inneres Kammerteil (16) mit einer vertikalen Achse (A-A) und einem ersten Boden (17) besitzt,
b) ein äußeres, das innere Kammerteil (16) mit Abstand umgebendes Kammerteil (22) besitzt, zwischen denen ein ringförmiger Raum (29) für die Rotation der Substrathalter (13) angeordnet ist, wobei das äußere Kammerteil (22) mit mehreren, in gleichem Winkelabstand angeordnete öffnungen (26) und daran angeschlossene Behandlungskammern (27, 28, 43) versehen ist und einen weiteren Boden (23) besitzt, der stationär und mit Abstand unterhalb des ersten Bodens (17) angeordnet ist,
c) für die synchrone Radialbewegung der Substrathalter (13) relativ zu den öffnungen (26) der Behandlungskammern (27, 28, 43) mindestens eine Lenkeranordnung (8, 57) aufweist, die um die Achse (A-A) drehbar zwischen dem ersten Boden (17) und dem zweiten Boden (23) angeordnet ist, und schließlich
d) eine Schleusenreihe (37) mit einer übergabekammer (39) für die sukzessive Beschickung der Anlage mit rahmenlos geführten Substraten.

8. Vakuum-Behandlungsanlage nach mindestens einem der Ansprüche 1 bis 7, **dadurch gekennzeichnet, daß**
die lineare, fluchtende Schleusenreihe (37) in tangentialer Ausrichtung zur Vakuumkammer (15) angeordnet ist und eine Eintrags schleuse (38), eine übergabekammer (39) und eine Austragsschleuse (40) mit zwischengeschalteten Vakuumventilen (41) enthält, wobei die Schleusenreihe (37) einen linearen Transportweg der Substrate vor und nach der Vakuumbehandlung definiert.

9. Vakuum-Behandlungsanlage nach mindestens einem der Ansprüche 1 bis 8, **dadurch gekennzeichnet, daß** die um die senkrechte Achse (A-A) drehbaren Substrathalter (13) nach oben hin um einen Winkel zwischen 1 und 20 Grad gegen die Achse (A-A) geneigt angeordnet sind.

10. Vakuum-Behandlungsanlage nach Anspruch 9, **dadurch gekennzeichnet, daß** die um die senkrechte Achse (A-A) drehbaren Substrathalter (13) nach oben hin um einen Winkel zwischen 3 und 15 Grad gegen die Achse (A-A) geneigt angeordnet sind.

11. Vakuum-Behandlungsanlage nach mindestens einem der Ansprüche 1 bis 10, **dadurch gekennzeichnet, daß** sich für die rahmenlose Führung der Substrate in den Schleusenkammern (38, 40) stationäre Substrathalter befinden, die unter den gleichen Winkeln zur Senkrechten stehen wie die drehbaren Substrathalter (13).

12. Vakuum-Behandlungsanlage nach mindestens einem der Ansprüche 1 bis 11, **dadurch gekennzeichnet, daß** die Substrathalter (13) an ihren unteren Enden Rollen (11) für die Aufnahme und Weitergabe der Substrate und darüber öffnungen für den Austritt von Gasen zur Ausbildung von Gaskissen zum reibungsfreien Transport der Substrate während ihrer Relativbewegung zum jeweiligen Substrathalter (13) aufweisen.

13. Vakuum-Behandlungsanlage nach mindestens einem der Ansprüche 1 bis 12, **dadurch gekennzeichnet, daß** die öffnungen (26) der Behandlungskammern (27, 28, 43) in bezug auf die ihnen gegenüber stehenden drehbaren Substrathalter (13) Ränder aufweisen, die in einer zur Ebene der Substrathalter (13) parallelen ebene liegen.

14. Vakuum-Behandlungsanlage nach Anspruch 13 , **dadurch gekennzeichnet, daß** die öffnungen (26) der Behandlungskammern (27, 28, 43) mit Blenden (46) zur Maskierung der Substrate während der Behandlung versehen sind.

15. Vakuum-Behandlungsanlage nach mindestens einem der Ansprüche 1 bis 14, **dadurch gekennzeichnet, daß** die Lenkeranordnungen (8, 57) für den Vorschub der drehbaren Substrathalter (13) ausschließlich Gelenke besitzen, mit denen die Substrathalter (13) ohne Auftreten von linearen Gleitreibungen bewegbar sind.

16. Vakuum-Behandlungsanlage nach Anspruch 5, **dadurch gekennzeichnet, daß** die kürzesten und oberen Glieder (65) der Trapez-Lenkeranordnungen (57) in ihrer Mitte weitere Gelenke besitzen, und daß jeweil zwei in Reihe geschaltete Trapez-Lenkeranordnungen (57) mittels Distanzlenkern (62) derart miteinander verbunden sind, daß die in Reihe geschalteten Trapez-Lenkeranordnungen (57) jeweils gleiche Winkelstellungen einnehmen.

17. Vakuum-Behandlungsanlage nach mindestens einem der Ansprüche 5 bis 7, **dadurch gekennzeichnet, daß** der Antriebsmechanismus (51) für die Welle (56) in dem inneren, zur Atmosphäre hin offenen Kammerteil (16) angeordnet ist.

18. Vakuum-Behandlungsanlage nach Anspruch 16, **dadurch gekennzeichnet, daß** die oberen Glieder (65) der Trapez-Lenkeranordnungen (57) fest angebrachte weitere Lenker (65a) besitzen, deren untere Enden über Gelenke mit Auslegern (61) verbunden sind, an deren äußeren Enden die Substrathalter (13) befestigt sind.

19. Vakuum-Behandlungsanlage nach Anspruch 18, **dadurch gekennzeichnet, daß** die oberen Glieder (65) und deren Lenker (65a) die Form eines "T" aufweisen.

20. Vakuum-Behandlungsanlage nach mindestens einem der Ansprüche 16 bis 19, **dadurch gekennzeichnet, daß** an der Welle (56) ein Tragflansch (63) angeordnet ist, der über Lenker (64) auf Winkelhebel (59) einwirkt, die auf dem Drehteller (58) gelagert sind und deren einer Schenkel ein Teil der jeweils innersten Trapez-Lenkeranordnungen (57) ist und durch den ein Verschwenken der Trapez-Lenkeranordnungen (57) herbeiführbar ist.

## Claims

1. Vacuum treatment installation for flat rectangular or square substrates in an at least substantially perpendicular position, comprising a vacuum chamber (15) with at least two treatment chambers (27, 28, 43) distributed on the circumference of the vacuum chamber (15) and open at the chamber side, a charging interlock (38), a discharging interlock (40) and a rotatable configuration of substrate holders (13) within the vacuum chamber (15) with a driving mechanism (1, 51) for the sequential rotation and the advance and retraction of the substrate holders (13) relative to the treatment chambers (27, 28, 43),
**characterized in**
**that** the substrate holders (13) in their lower regions are connected with the driving mechanism (1, 51) via connecting rod configurations (8, 57) and that at least the lower pivot bearings of the connecting rod configurations (8, 57) are disposed below a horizontal center line (M) of the height (H) of the bearing surface of the substrate holders (13).

2. Vacuum treatment installation as claimed in claim 1, **characterized in that** all pivot bearings of the connecting rod configurations (8, 57) are disposed below the horizontal center line (M) of the height (H) of the bearing surface of the substrate holders (13).

3. Vacuum treatment installation as claimed in claim 1, **characterized in that** the driving mechanism (1) for each substrate holder (13) has extension arms (4) disposed pairwise, on each of which is suspended a parallelogram connecting rod configuration (8).

4. Vacuum treatment installation as claimed in claim 3, **characterized in that** the lower pivot bearings of the parallelogram connecting rod configurations are each disposed on a U-form stirrup (9), whose outwardly directed shanks (9a) are connected with a crosstie bar (10), which forms the lower termination of the particular substrate holder (13).

5. Vacuum treatment installation as claimed in claims 1 and 2, **characterized in that** the driving mechanism (51) possesses a rotary plate (58), on which a group of trapezoidal connecting rod configurations (57) is set up for each substrate holder (13),

6. Vacuum treatment installation as claimed in claim 5, **characterized in that** the driving mechanism (51) is a rotary and lifting drive with a concentric shaft (56), through whose vertical movement the trapezoidal connecting rod configurations (57) is brought to act with radial movements onto the substrate holders (13).

7. Vacuum treatment installation as claimed in at least one of claims 1 to 6, **characterized in that** the vacuum chamber (15)
a) comprises a pot-form rotationally symmetric and stationary inner chamber component (16) with a vertical axis (A-A) and a first bottom (17),
b) comprises an outer chamber component (22) encompassing at an offset the inner chamber component (16), between which an annulaf space (29) for the rotation of the substrate holders (13) is disposed, the outer chamber component (22) being provided with several openings (26) disposed at the same angular distance and treatment chambers (27, 28, 43) connected thereon, and comprises a further bottom (23) disposed stationarily and at a spacing beneath the first bottom (17),
c) for the synchronous radial movement of the substrate holders (13) relative to the openings (26) of the treatment chambers (27, 28, 43) comprises at least one connecting rod configuration (8,57), which is disposed rotatably about the axis (A-A) between the first bottom (17) and the second bottom (23), and lastly
d) comprises a series of interlocks (37) with a transfer chamber (39) for the successive charging of the installation with substrates guided free of frames.

8. Vacuum treatment installation as claimed in at least one of claims 1 to 7,
**characterized in**
**that** the linear aligned interlock series (37) is disposed tangentially oriented with respect to the vacuum chamber (15) and comprises a charging interlock (38), a transfer chamber (39) and a discharging interlock (40) with interconnected vacuum valves (41), the series of interlocks (37) defining a linear transport path of the substrates before and after the vacuum treatment.

9. Vacuum treatment installation as claimed in at least one of claims 1 to 8, **characterized in that** the substrate holders (13) rotatable about the perpendicular axis (A-A) are disposed sloped upwardly at an angle between 1 and 20 degrees with respect to the axis (A-A).

10. Vacuum treatment installation as claimed in claim 9, **characterized in that** the substrate holders (13) rotatable about the perpendicular axis (A-A) are disposed sloped upwardly at an angle between 3 and 15 degrees with respect to the axis (A-A).

11. Vacuum treatment installation as claimed in at least one of claims 1 to 10, **characterized in that** for the frame-less guidance of the substrates are disposed in the interlock chambers (38, 40) stationary substrate holders, which are disposed at the same angle with respect to the vertical as the rotatable substrate holders (13).

12. Vacuum treatment installation as claimed in at least one of claims 1 to 11, **characterized in that** the substrate holders (13) comprise at their lower ends rollers (11) for receiving and transferring the substrates and thereabove openings for the escape of gases for the formation of gas cushions for the frictionless transport of the substrates during their relative movement to the particular substrate holder (13).

13. Vacuum treatment installation as claimed in at least one of claims 1 to 12, **characterized in that** the openings (26) of the treatment chambers (27, 28, 43) with respect to the rotating substrate holders (13) opposing them have edges disposed in a plane parallel to the plane of the substrate holders (13).

14. Vacuum treatment installation as claimed in claim 13, **characterized in that** the openings (26) of the treatment chambers (27, 28, 43) are provided with screens (46) for masking the substrates during the treatment.

15. Vacuum treatment installation as claimed in at least one of claims 1 to 14, **characterized in that** the connecting rod configurations (8, 57) for the advance of the rotatable substrate holders (13) exdusively have articulations with which the substrate holders (13) can be moved without the occurrence of linear sliding friction.

16. Vacuum treatment installation as claimed in claim 5, **characterized in that** the shortest and upper members (65) of the trapezoidal connecting rod configurations (57) have in their midpoints further articulations, and that in each instance two serially connected trapezoidal connecting rod configurations (57) are connected with one another by means of distance connecting rods (62) such that each of the serially connected trapezoidal connecting rod configurations (57) assumes the same angular position.

17. Vacuum treatment installation as claimed in at least one of claims 5 to 7, **characterized in that** the driving mechanism (51) for the shaft (56) is disposed in the inner chamber component (16) open to the atmosphere.

18. Vacuum treatment installation as claimed in claim 16, **characterized in that** the upper members (65) of the trapezoidal connecting rod configurations (57) have fixedly situated further connecting rods (65a), whose lower ends are connected via articulations with extension arms (61) at whose outer ends the substrate holders (13) are fastened.

19. Vacuum treatment installation as claimed in claim 18, **characterized in that** the upper members (65) and their connecting rods (65a) have the form of a "T".

20. Vacuum treatment installation as claimed in at least one of claims 16 to 19, **characterized in that** on the shaft (56) is disposed a bearing flange (63), which acts via connecting rods (64) onto angle levers (59) fulcrumed on the rotary plate (58) and whose one shank is a portion of the particular innermost trapezoidal connecting rod configurations (57) and through which a swiveling of the trapezoidal connecting rod configurations (57) can be brought about.

## Revendications

1. Installation de traitement sous vide pour substrats plans rectangulaires ou carrés dans une position au moins substantiellement verticale, comprenant une chambre à vide (15) avec au moins deux chambres de traitement (27, 28, 43) réparties sur la circonférence de la chambre à vide (15) et ouvertes du côté de la chambre, un sas d'admission (38), un sas d'évacuation (40) et un ensemble tournant de supports de substrat (13) à l'intérieur de la chambre à vide (15) avec un mécanisme d'entraînement (1, 51) pour la rotation séquentielle et l'avance et le retrait des supports de substrat (13) par rapport aux chambres de traitement (27, 28, 43), **caractérisée en ce que** les supports de substrat (13) sont reliés dans leurs parties inférieures au mécanisme d'entraînement (1, 51) par l'intermédiaire d'ensembles de dispositifs de guidage (8, 57), et **en ce qu'**au moins les paliers de pivotement inférieurs des ensembles de dispositifs de guidage (8, 57) sont disposés au-dessous d'une ligne médiane horizontale (M) de la hauteur (H) de la surface portante des supports de substrat (13).

2. Installation de traitement sous vide selon la revendication 1, **caractérisée en ce que** tous les paliers de pivotement des ensembles de dispositifs de guidage (8, 57) sont disposés au-dessous de la ligne médiane horizontale (M) de la hauteur (H) de la surface portante des supports de substrat (13).

3. Installation de traitement sous vide selon la revendication 1, **caractérisée en ce que** le mécanisme d'entraînement (1) possède pour chaque support de substrat (13) des avant-bras (4) disposés par paires, sur lesquels respectivement un ensemble de dispositifs de guidage en forme de parallélogramme (8) est disposé en suspension.

4. Installation de traitement sous vide selon la revendication 3, **caractérisée en ce que** les paliers de pivotement inférieurs des ensembles de dispositifs de guidage en forme de parallélogramme sont disposés respectivement sur un étrier en forme de U (9) dont les branches tournées vers l'extérieur (9a) sont reliées à une traverse (10) qui constitue la terminaison inférieure du support de substrat (13) respectif.

5. Installation de traitement sous vide selon les revendications 1 et 2, **caractérisée en ce que** le mécanisme d'entraînement (51) possède un plateau tournant (58) sur lequel un groupe d'ensembles de dispositifs de guidage en forme de trapèze (57) est posé pour chaque support de substrat (13).

6. Installation de traitement sous vide selon la revendication 5, **caractérisée en ce que** le mécanisme d'entraînement (51) est un entraînement rotatif et élévateur avec un arbre concentrique (56) dont le mouvement vertical permet d'amener les ensembles de dispositifs de guidage en forme de trapèze (57) par des mouvements radiaux à agir sur les supports de substrat (13).

7. Installation de traitement sous vide selon au moins l'une quelconque des revendications 1 à 6, **caractérisée en ce que** la chambre à vide (15)
a) possède une partie de chambre intérieure en forme de pot, à symétrie de révolution et stationnaire (16) avec un axe vertical (A-A) et un premier fond (17),
b) possède une partie de chambre extérieure (22) entourant la partie de chambre intérieure (16) à une certaine distance, entre lesquelles un espace annulaire (29) est disposé pour la rotation du support de substrat (13), la partie de chambre extérieure (22) étant munie d'ouvertures (26) disposées à intervalle angulaire égale et de chambres de traitement (27, 28, 43) adjacentes à celles-ci, et possède un autre fond (23) qui est disposé de façon stationnaire et à distance au-dessous du premier fond (17),
c) présente pour le mouvement radial synchrone des supports de substrat (13) par rapport aux ouvertures (26) des chambres de traitement (27, 28, 43) au moins un ensemble de dispositifs de guidage (8, 57) qui est disposé de façon à pouvoir tourner autour de l'axe (A-A) entre le premier fond (17) et le deuxième fond (23), et enfin
d) possède une série de sas (37) avec une chambre de transfert (39) pour la charge successive de l'installation avec des substrats guidés sans cadre.

8. Installation de traitement sous vide selon au moins l'une quelconque des revendications 1 à 7, **caractérisée en ce que** la série de sas linéaire, en alignement (37) est disposée dans une orientation tangentielle à la chambre à vide (15) et comprend un sas d'admission (38), une chambre de transfert (39) et un sas d'évacuation (40) avec des vannes à vide (41) intercalées, la série de sas (37) définissant un trajet de transport linéaire des substrats avant et après le traitement sous vide.

9. Installation de traitement sous vide selon au moins l'une quelconque des revendications 1 à 8, **caractérisée en ce que** les supports de substrat (13) pouvant tourner autour de l'axe vertical (A-A) sont disposés de façon inclinée vers le haut sous un angle entre 1 et 20 degrés par rapport à l'axe (A-A) .

10. Installation de traitement sous vide selon la revendication 9, **caractérisée en ce que** les supports de substrat (13) pouvant tourner autour de l'axe vertical (A-A) sont disposés de façon inclinée vers le haut sous un angle entre 3 et 15 degrés par rapport à l'axe (A-A).

11. Installation de traitement sous vide selon au moins l'une quelconque des revendications 1 à 10, **caractérisée en ce que** pour le guidage sans cadre des substrats, des supports de substrat stationnaires se trouvent dans les chambres de sas (38, 40) qui se trouvent sous les mêmes angles par rapport à la verticale que les supports de substrat tournants (13).

12. Installation de traitement sous vide selon au moins l'une quelconque des revendications 1 à 11, **caractérisée en ce que** les supports de substrat (13) présentent à leurs extrémités inférieures des rouleaux (11) pour la réception et le transfert des substrats et au-dessus de ceux-ci des ouvertures destinées la sortie de gaz afin de réaliser des coussins gazeux pour un transport exempt de friction des substrats pendant leur mouvement relatif vers le support de substrat (13) respectif.

13. Installation de traitement sous vide selon au moins l'une quelconque des revendications 1 à 12, **caractérisée en ce que** les ouvertures (26) des chambres de traitement (27, 28, 43) présentent par rapport aux supports de substrat tournants (13) opposés à celles-ci des bords qui se trouvent dans un plan parallèle au plan des supports de substrat (13).

14. Installation de traitement sous vide selon la revendication 13, **caractérisée en ce que** les ouvertures (26) des chambres de traitement (27, 28, 43) sont munies d'écrans (46) pour masquer les substrats pendant le traitement.

15. Installation de traitement sous vide selon au moins l'une quelconque des revendications 1 à 14, **caractérisée en ce que** les ensembles de dispositifs de guidage (8, 57) possèdent pour l'avance des supports de substrat tournants (13) exclusivement des articulations avec lesquelles les supports de substrat (13) peuvent être déplacés sans l'apparition de frictions de glissement linéaires.

16. Installation de traitement sous vide selon la revendication 5, **caractérisée en ce que** les membres les plus courts et supérieurs (65) des ensembles de dispositifs de guidage en forme de trapèze (57) possèdent au centre de ceux-ci d'autres articulations et **en ce que** respectivement deux ensembles de dispositifs de guidage en forme de trapèze (57) montés en série sont reliés au moyen de dispositifs de guidage d'écartement (62) de telle sorte que la série d'ensembles de dispositifs de guidage en forme de trapèze montés en série (57) occupe respectivement des positions angulaires identiques.

17. Installation de traitement sous vide selon au moins l'une quelconque des revendications 5 à 7, **caractérisée en ce que** le mécanisme d'entraînement (51) pour l'arbre (56) est disposé dans la partie de chambre intérieure, ouverte vers l'atmosphère (16).

18. Installation de traitement sous vide selon la revendication 16, **caractérisée en ce que** les membres supérieurs (65) des ensembles de dispositifs de guidage en forme de trapèze (57) possèdent d'autres dispositifs de guidage montés de façon stationnaire (65a) dont les extrémités inférieures sont reliées par l'intermédiaire d'articulations à des avant-bras (61) aux extrémités extérieures desquels sont fixés les supports de substrat (13).

19. Installation de traitement sous vide selon la revendication 18, **caractérisée en ce que** les membres supérieurs (65) et leurs dispositifs de guidage (65a) présentent la forme d'un "T".

20. Installation de traitement sous vide selon au moins l'une quelconque des revendications 16 à 19, **caractérisée en ce que** sur l'arbre (56), une bride de support (63) est disposée qui agit par l'intermédiaire des dispositifs de guidage (64) sur des leviers coudés (59) qui sont logés sur le plateau tournant (58) et dont une branche fait partie des ensembles de dispositifs de guidage en forme de trapèze (57) respectivement les plus à l'intérieur et qui peut provoquer un pivotement des ensembles de dispositifs de guidage en forme de trapèze (57).
